# EUROPEAN PATENT APPLICATION

(11) **EP 1 906 250 A2**
(43) Date of publication of application: **02.04.2008**
(21) Application number: 07019171.3
(22) Date of filing: 28.09.2007
(51) Int. Cl.: G03F 7/16

(54) **Method for preparation of photosensitive lithographic printing plate**

(30) Priority: 29.09.2006 JP 2006267851
(71) Applicant: FUJIFILM Corporation, Minato-ku Tokyo (JP)
(72) Inventor: Mori, Takanori, Haibara-gun Shizuoka (JP)
(74) Representative: HOFFMANN EITLE

(57) **Abstract**

A method for preparation of a photosensitive lithographic printing plate including a support, a photopolymerizable photosensitive layer containing an addition-polymerizable compound having an ethylenically unsaturated double bond, an alkali-soluble or alkali-swellable binder and a photopolymerization initiator and an overcoat layer provided in this order, the method comprising: conducting heat treatment of the photosensitive lithographic printing plate having the photopolymerizable photosensitive layer which is dried at a temperature of from 30 to 60°C.

## Description

### FTELD OF THE INVENTION

The present invention relates to a method for preparation of a photosensitive lithographic printing plate. More particularly, it relates to a method for preparation of a negative-working photosensitive lithographic printing plate which is excellent in sensitivity stability and exhibits high sensitivity and high printing durability.

### BACKGROUND OF THE INVENTION

Heretofore, a lithographic printing plate is obtained by a plate-making method wherein a photosensitive lithographic printing plate having a construction comprising a photosensitive resin layer provided on a support having a hydrophilic surface is ordinarily subjected to floodwise exposure (mask exposure) via a lith film and then while leaving the photosensitive resin layer for forming the image area, the other unnecessary photosensitive resin layer is removed with a developer. However, with the recent progress of digitized techniques, a computer-to-plate (CTP) technique of directly conducting exposure process on the surface of the photosensitive lithographic printing plate by scanning according to digitized image data with highly convergent light, for example, a laser beam, without using a lith film has been developed. Photosensitive lithographic printing plates adapted for the technique have also been developed.

As the photosensitive lithographic printing plate suitable for exposure with a laser beam, a photosensitive lithographic printing plate (polymerizable lithographic printing plate) having a polymerizable photosensitive resin layer (polymerizable photosensitive layer) is exemplified. Such a photosensitive lithographic printing plate is preferable because the polymerizable photosensitive layer is easily enable to increase sensitivity by appropriately selecting a photopolymerization initiator or a photopolymerization initiation system (hereinafter also simply referred to as an "initiator" and an "initiation system", respectively) in comparison with other conventional photosensitive layers.

However, although the photosensitive lithographic printing plate as described above is capable of forming an image with low energy, it also involves a problem in that the sensitivity thereof is unstable particularly just after the production and a long period of time is required until the sensitivity becomes stable so that it can be sipped as a commercial product.

In JP-A-2005-326493 (the term "JP-A" as used herein means an "unexamined published Japanese patent application") (corresponding to US 2005/0255407A1), a photosensitive lithographic printing plate wherein crystallinity of a water-soluble polymer in an overcoat layer (oxygen blocking layer) is controlled is described. However, the photosensitive lithographic printing plate is still insufficient in the stabilization of sensitivity and it is difficult to use without an operation, for example, change in the setting of exposure amount or change in the calibration.

### SUMMARY OF THE INVENTION

An object of the present invention is to provide a method for preparation of a photosensitive lithographic printing plate which is suitable for drawing with laser light, has stable sensitivity just after the production and exhibits high sensitivity and high printing durability.

As a result of intensive investigations, the inventor has found that the above-described object can be achieved by the constitution described below.

The invention includes the following items.
(1) A method for preparation of a photosensitive lithographic printing plate comprising a support, a photopolymerizable photosensitive layer containing an addition-polymerizable compound having an ethylenically unsaturated double bond, an alkali-soluble or alkali-swellable binder and a photopolymerization initiator and an overcoat layer provided in this order, the method comprising a step of conducting heat treatment of the photosensitive lithographic printing plate having the dried photopolymerizable photosensitive layer at a temperature of 30 to 60°C (a step of conducting heat treatment of the photopolymerizable photosensitive layer, which is formed over the support by applying a solution for forming the photopolymerizable photosensitive layer and drying the applied solution, at a temperature of 30 to 60°C).
(2) The method for preparation of a photosensitive lithographic printing plate as described in (1) above, wherein the heat treatment is conducted after formation of the overcoat layer.
(3) The method for preparation of a photosensitive lithographic printing plate as described in (1) or (2) above, wherein the heat treatment is conducted at a temperature of 35 to 50°C.
(4) The method for preparation of a photosensitive lithographic printing plate as described in any one of (1) or (3) above, wherein time for the heat treatment is at least 5 days.
(5) The method for preparation of a photosensitive lithographic printing plate as described in any one of (1) or (4) above, wherein the addition-polymerizable compound having an ethylenically unsaturated double bond is a compound having four or more ethylenically unsaturated double bonds in its molecule.

Although the function mechanism according to the invention is not quite clear, it is presumed as follows.

In a photosensitive lithographic printing plate after the production which is not undergoing a heat treatment, the sensitivity is not stabilized and such a photosensitive lithographic printing plate provides only a lithographic printing plate having a low contrast between the image area and the non-image area after a development processing. The reason for this is not always clear but it is estimated that the distribution of the addition-polymerizable compound having an ethylenically unsaturated double bond and the alkali-soluble or alkali-swellable binder in the layer is involved in the phenomenon. Specifically, it is estimated that the sensitivity is not stabilized because the phase separation of the addition-polymerizable compound and the binder gradually proceeds after the production. The heat treatment after the production according to the invention evidently has the effect of accelerating the formation of state of phase separation and as a result, a photosensitive lithographic printing plate which is excellent in the sensitivity stability, sensitivity and printing durability is able to be obtained.

According to the present invention, a method for preparation of a photosensitive lithographic printing plate which is suitable for drawing with laser light, has stable sensitivity just after the production and exhibits high sensitivity and high printing durability can be provided.

### DETAILED DESCRIPTION OF THE INVENTION

Preferable embodiments of the method for preparation of a photosensitive lithographic printing plate according to the invention are described below, but the invention should not be construed as being limited thereto.

### [Support]

The support for use in the invention includes a dimensionally stable aluminum or its alloy (for example, aluminum alloy with silicon, copper, manganese, magnesium, chromium, zinc, lead, bismuth or nickel). Ordinarily, conventionally known materials described in Aluminum Handbook, 4th edition, published by Keikinzoku Kyokai (1990), for example, JIS A 1050 material, JIS A 1100 material, JIS A 3103 material, JIS A 3004 material, JIS A 3005 material, or alloys prepared by adding 0.1% by weight or more of magnesium to these materials for the purpose of increasing tensile strength can be used.

The aluminum plate may be an aluminum plate produced by a continuous casting rolling process, as well as an aluminum plate produced by conventional semi-continuous casting process (DC process). As the continuous casting rolling process, for example, a twin roll process, a belt caster process or a block caster process can be used. The content of the hetero element in the alloy is 10% by weight or less. The thickness of the aluminum plate is preferably from about 0.1 to about 0.6 mm. Further, a plastic film or paper on which aluminum or aluminum alloy is laminated or deposited may also be used.

### [Surface treatment of support]

When the support is an aluminum plate, the surface of aluminum plate is ordinarily subjected to various treatments according to the purpose. According to a conventional treatment method, the aluminum plate is first subjected to surface cleaning by a degreasing treatment or an electrolytic polishing treatment and a desmut treatment. Then, it was subjected to a mechanical surface roughening treatment and/or an electrochemical surface roughening treatment to provide fine concavities and convexities on the surface of the aluminum plate. At this time, a chemical etching treatment and a desmut treatment may be added in some cases. Thereafter, the aluminum plate is subjected to an anodizing treatment in order to increase abrasion resistance of the surface and then it is subjected to a hydrophilization treatment and/or a sealing treatment, if desired.

It is preferred to conduct squeezing of solution through nip roller and washing with water, for example, by means of a spray between the respective treatments in order to prevent the carrying over of the treating solution of the preceding treatment into the next treatment step. An overflow waist solution of the electrolyte used in the electrochemical surface roughening treatment can be used as a solution for the desmut treatment and in such a case, the water washing treatment after the desmut treatment may be omitted.

### (Degreasing Electrolytic polishing treatment)

For the purpose of removing rolling oil, natural oxidizing film and stain of the aluminum plate and of performing uniform electrochemical surface roughening, an electrolytic polishing treatment of the aluminum plate in an aqueous acidic solution or a chemical etching treatment of the aluminum plate in an aqueous acid or alkali solution is conducted. The dissolution amount of the aluminum plate by the treatment is preferably from 1 to 30 g/m², and more preferably from 1.5 to 20 g/m²,

### (1) Electrolytic polishing treatment

Examples of the formulation of electrolytic polishing treatment classified by the material are described in Fujio Mamiya, Senjo Sekkei (Cleaning designing), No. 21, pages 65 to 72 (1984).

A known aqueous solution for use in the electrolytic polishing is used in the invention. It is preferably an aqueous solution mainly comprising sulfuric acid or phosphoric acid, more preferably an aqueous solution mainly comprising phosphoric acid.

As a specific aqueous solution for use in the electrolytic polishing, the phosphoric acid concentration is preferably from 20 to 90% by weight, and more preferably from 40 to 80% by weight. With respect to other conditions of the electrolytic polishing, the temperature of solution is selected from the range of 10 to 90°C (preferably from 50 to 80°C), the current density is selected from the range of 1 to 100 A/dm² (preferably from 5 to 80 A/dm²), and the electrolysis time is selected from the range of 1 to 180 seconds. The aqueous phosphoric acid solution may contain sulfuric acid, chromic acid, hydrogen peroxide, citric acid, hydrofluoric acid or phthalic anhydride in an amount of 1 to 50% by weight.

As the current, direct current, pulse direct current or alternating current can be used and continuous direct current is preferable. As the electrolysis treatment apparatus, a known apparatus used in electrolysis treatment can be used, for example, a flat-type cell or a radial-type cell. The current speed of the aqueous solution may be a parallel flow with or a counter flow to the aluminum plate and is selected from the range of 0.01 to 10,000 cm/min.

The distance between the aluminum plate and the electrode is preferably from 0.3 to 10 cm, and particularly preferably from 0. 8 to 2 cm. The power supply method may be a direct supply method using a conductor roll or an indirect supply method using no conductor roll (liquid power supply method). With respect to the electrode material or structure, a known material or structure used in the electrolysis may be used and the cathode material is preferably carbon and the anode material is preferably ferrite, iridium oxide or platinum.

### (2) Chemical etching treatment in aqueous acid or alkali solution

The chemical etching treatment of the aluminum plate in an aqueous acid or alkali solution is described in detail in U.S. Patent 3,834,398 and such known means can be used. With respect to the acid or alkali which can be used in the aqueous acid or alkali solution, those described in JP-A-57-16918 can be used individually or in combination. The treatment is preferably performed at a solution temperature of 25 to 90°C for from 1 to 120 seconds. The concentration of the aqueous acid solution is preferably from 0.5 to 25% by weight, and the concentration of aluminum dissolved in the aqueous acid solution is preferably from 0.5 to 5% by weight. The concentration of the aqueous alkali solution is preferably from 5 to 30% by weight, and the concentration of aluminum dissolved in the aqueous alkali solution is preferably from 1 to 30% by weight.

### (Desmut treatment)

When the chemical etching is performed using an aqueous solution of a base, smut is ordinarily produced on the aluminum surface. In this case, the aluminum plate is treated (desmut treatment) with phosphoric acid, nitric acid, sulfuric acid, chromic acid or a mixed acid containing two or more of these acids.

In the aqueous acidic solution used, from 0 to 5% by weight of aluminum may be dissolved. The treatment is performed at a liquid temperature of ordinary temperature to 70°C for a processing time of preferably from 1 to 30 seconds. Also, as the acidic solution, a waste solution of the electrolytic solution used in the electrochemical surface roughening treatment can be used. In this case, however, it is necessary to take care that the aluminum plate is not dried and the components in the desmut solution do not precipitate.

After completion of desmut treatment, squeezing of solution through a nip roller and washing with water by means of a spray are preferably performed so as not to carry over the treatment solution to the next step. The washing with water may be omitted when the next step uses the same aqueous solution.

### (Mechanical surface roughening treatment)

In order to obtain a good aluminum support, it is ordinary to conduct graining of the surface of aluminum plate to provide fine concavities and convexities. For the graining, a mechanical surface roughening treatment, for example, ball graining, brush graining, wire graining or blast graining is ordinarily known and the brush graining treatment is excellent as a large scale and continuous treatment.

In the brush graining treatment, one or plurality of brushes are ordinarily used, and a method wherein plurality of brushes of one specific kind are used as described in JP-B-50-40047 (the term "JP-B" as used herein means an "examined Japanese patent publication") and a method wherein plurality of brushes different in the material of bristle, diameter of bristle or cross-sectional shape of bristle are used as described in JP-A-6-135175. Specifically, a slurry solution, for example, of silica sand or aluminum hydroxide is sprayed on the surface of aluminum plate and nylon brush rolls having a diameter of bristle of 0.2 to 0.9 mm are rotated at 50 to 500 rpm to perform the mechanical surface roughening treatment. The pushing power of brush is preferably from 0.2 to 15 kw, more preferably from 0.5 to 10 kw, in terms of electric power consumption of a rotation drive motor (substantial electric power excluding mechanical loss of the drive motor) .

### (Electrochemical surface roughening treatment)

(1) In the electrochemical surface roughening treatment using direct current, as a solution mainly comprising hydrochloric acid or nitric acid, a solution for use in conventional electrochemical surface roughening treatment using direct current can be used. The aqueous solution used can be obtained by adding one or more of hydrochloric acid or nitric acid compounds having nitric ion, for example, aluminum nitrate, sodium nitrate or ammonium nitrate, or hydrochloric ion, for example, aluminum chloride, sodium chloride or ammonium chloride in an amount of 1 g/l to saturation, to 1 to 100 g/l of an aqueous hydrochloric acid or nitric acid solution. In the aqueous solution mainly comprising hydrochloric acid or nitric acid, a metal contained in the aluminum alloy, for example, iron, copper, manganese, titanium, magnesium or silica, may be dissolved. A solution obtained by adding, for example, aluminum chloride or aluminum nitrate to an aqueous solution containing from 0. 5 to 2% by weight of hydrochloric acid or nitric acid so as to have an aluminum ion concentration of 3 to 50 g/l is preferably used. The temperature is preferably from 10 to 60°C, and more preferably from 25 to 50°C. As a treating apparatus for use in the electrochemical surface roughening using direct current, a known treating apparatus using direct current can be used and an apparatus where a pair or more of anode and cathode are alternately arranged as described in JP-A-1-141094 is preferably used. Examples of known apparatuses are described, for example, in JP-A-1-141094, JP-A-8-67078, JP-A-61-19115 and JP-B-57-44760. The direct current for use in the electrochemical surface roughening is preferably direct current having a ripple ratio of 20% or less. The current density is preferably from 10 to 200 A/dm², and the quantity of electricity at the anodic time of the aluminum plate is preferably from 10 to 1,000 C/dm³.
   The anode can be selected to use from known electrodes for oxygen generation, for example, ferrite, iridium oxide, platinum and platinum cladded or plated to a valve metal, for example, titanium, niobium or zirconium. The cathode can be selected to use from carbon, platinum, titanium, niobium, zirconium, stainless steel and an electrode used as a cathode of fuel cell.
(2) In the electrochemical surface roughening treatment using alternating current, as a solution mainly comprising hydrochloric acid or nitric acid, a solution for use in conventional electrochemical surface roughening treatment using alternating current can be used. The aqueous solution used can be obtained by adding one or more of hydrochloric acid or nitric acid compounds having nitric ion, for example, aluminum nitrate, sodium nitrate or ammonium nitrate, or hydrochloric ion, for example, aluminum chloride, sodium chloride or ammonium chloride in an amount of 1 g/l to saturation, to 1 to 100 g/l of an aqueous hydrochloric acid or nitric acid solution. In the aqueous solution mainly comprising hydrochloric acid or nitric acid, a metal contained in the aluminum alloy, for example, iron, copper, manganese, titanium, magnesium or silica, may be dissolved. A solution obtained by adding, for example, aluminum chloride or aluminum nitrate to an aqueous solution containing from 0.5 to 2% by weight of hydrochloric acid or nitric acid so as to have an aluminum ion concentration of 3 to 50 g/l is preferably used. The temperature is preferably from 10 to 60°C, and more preferably from 25 to 50°C.
(3) The alternating current power waveform used in the electrochemical surface roughening includes, for example, a sine waveform, a square waveform, a trapezoidal waveform and a triangle waveform and is preferably a square waveform or a trapezoidal waveform and particularly preferably a trapezoidal waveform. The time (TP) necessary for the current starting from 0 to reach the peak is preferably from 1 to 3 msec. When the TP is less than 1 msec, treatment unevenness referred to as a chatter mark generating perpendicularly to the running direction of the aluminum plate is apt to occur. When the TP is larger than 3 msec, the influence of a trace component which spontaneously increases in the electrolytic treatment in an aqueous nitric solution, represented by an ammonium ion, in the electrolyte used in the electrochemical surface roughening treatment is apt to arise, resulting in difficulty in performing uniform graining.
(4) A duty ratio of the trapezoidal waveform alternating current is usably from 1:2 to 2:1, In the indirect supply method using no conductor roll as described in JP-A-5-19300, the duty ratio of 1:1 is preferable. Frequency of the trapezoidal waveform alternating current is usably from 0.1 to 120 Hz, and preferably from 50 to 70 Hz. When the frequency is less than 50 Hz, a carbon electrode as the main electrode may tend to dissolved and whereas, when it is larger than 70 Hz, the influence of inductance component on the power supply circuit is apt to arise, resulting in increase in the power supply cost. However, when an aluminum alloy containing Cu in an amount exceeding 0.1% by weight is used, alternating current having a frequency of 0.1 to 10 Hz is preferably used. The current density is preferably from 10 to 200 A/dm², in terms of the peak value of the current waveform.
(5) With respect to the electrolytic cell used in the electrochemical surface roughening, a known electrolytic cell used in the surface treatment, for example, a vertical-type cell, a flat-type cell or a radial-type cell may be used and the radial-type electrolytic cell as described in JP-A-5-195300 is particularly preferred. The electrolyte passing through the electrolytic cell may flow in parallel with or counter to the running of the aluminum web.
(6) To the electrolytic cell, one or more alternating current power sources may be connected. It is preferred to control the current ratio between the anode and the cathode of the alternating current applied to the aluminum web opposing the main electrode and also to provide an auxiliary anode and divide the flow of a part of the alternating current for the purpose of preventing dissolution of carbon of the main electrode. By dividing a part of the current value through a rectifying device or a switch element and flowing it as direct current to an auxiliary anode provided in a cell separately from two main electrodes, the ratio between the current value participating in the anode reaction acting on the aluminum web opposing the main electrodes and the current value participating in the cathode reaction can be controlled. The ratio between the quantity of electricity participating in the anode reaction acting on the aluminum web opposing the main electrodes and the quantity of electricity participating in the cathode reaction (quantity of electricity at the cathodic time/quantity of electricity at the anodic time) is preferably from 0.3 to 0.95.
(7) It is described in JP-A-6-135175 that as the alternating current power waveform used in the electrochemical surface roughening step, a sine waveform, a trapezoidal waveform a square waveform is used. It is described in JP-A-5-195300 that as the electrolytic cell used in the electrochemical surface roughening, a radial-type cell is used and an auxiliary anode is provided together with the main electrode in the same cell. Further, it is described in JP-B-6-37716 that a part of the current value is divided to flow as direct current to an auxiliary anode provided in a cell separately from two main electrodes.
(8) The electrochemical surface roughening treatment of the aluminum plate in an aqueous solution mainly comprising nitric acid or hydrochloric acid using direct current or alternating current in the quantity of electricity of 10 to 1,000 C/dm³ is performed uses trapezoidal waveform alternating current having the time necessary for the current starting from 0 to reach the peak of 1 to 3 msec and the frequency of 50 to 70 Hz in an aqueous acidic solution.

### (Chemical etching treatment (with acidic or alkaline solution))

For the purpose of smoothening of the grained surface having fine concavities and convexities formed by the mechanical surface roughening treatment and electrochemical surface roughening treatment and of removing smut or the like, a chemical etching treatment is performed. The details of the etching method are described in U.S. Patent 3,834,398 and such known means can be used. With respect to the acid or alkali which can be used in the aqueous acidic or alkaline solution, those described in JP-A-57-16918 can be used individually or in combination. The treatment is preferably performed at a solution temperature of 25 to 90°C for from 1 to 120 seconds. The concentration of the aqueous acidic solution is preferably from 0.5 to 25% by weight, and the concentration of aluminum dissolved in the aqueous acidic solution is preferably from 0.5 to 5% by weight. The concentration of the aqueous alkaline solution is preferably from 5 to 30% by weight, and the concentration of aluminum dissolved in the aqueous alkaline solution is preferably from 1 to 30% by weight.

The etching treatment is performed in the aqueous acid or alkali solution so as to have the dissolution amount of aluminum of 1 to 30 g/m² (the etching treatment after the mechanical surface roughening treatment) or so as to have the dissolution amount of aluminum of 0.1 to 3 g/m² (the etching treatment after the electrochemical surface roughening treatment).

When the chemical etching is performed using an aqueous solution of a base, smut is ordinarily produced on the aluminum surface. In this case, the aluminum plate is treated (so-called desmut treatment) with phosphoric acid, nitric acid, sulfuric acid, chromic acid or a mixed acid containing two or more of these acids (same as the description on the desmut treatment above).

### (Anodizing treatment)

The anodizing treatment is performed in order to increase the water-retention property or the abrasion resistance on the surface of the aluminum plate. As the electrolyte used in the anodizing treatment of the aluminum plate, any material can be used as long as it forms a porous oxide film. Ordinarily, sulfuric acid, phosphoric acid, oxalic acid, chromic acid or a mixed solution thereof is used. The concentration of the electrolyte can be appropriately determined depending on the kind of the electrolyte. Since the condition of the anodizing treatment may vary depending on the electrolyte used, it cannot be definitely specified, however, it is ordinarily suitable that the concentration of the electrolyte is from 1 to 80% by weight, the liquid temperature is from 5 to 70°C, the current density is from 1 to 60 A/dm², the voltage is from 1 to 100 V and the electrolysis time is from 5 to 300 seconds.

The sulfuric acid method is usually performed with direct current, however, alternating current also may be used. The amount of the anodized film is suitably in a range of 0.5 to 10 g/m². The electrolytic treatment is performed using sulfuric acid at concentration of 5 to 30% by weight, in a temperature range of 20 to 60°C for a period of 5 to 250 seconds. The electrolyte preferably contains an aluminum ion. Further, the current density is preferably from 1 to 50 A/dm². In the phosphoric acid method, the treatment is performed at concentration of 5 to 50% by weight, in a temperature range of 30 to 60°C for a period of 10 to 300 seconds and at current density of 1 to 15 A/dm². The amount of the anodized film is preferably 1.0 g/m² or more, and more preferably in a range of 2.0 to 6.0 g/m².

### (Hydrophilization treatment)

After performing the anodizing treatment, the aluminum surface is subjected to a hydrophilization treatment, if desired. The hydrophilization treatment for use in the invention includes an alkali metal silicate (for example, an aqueous sodium silicate solution) method described in U.S. Patents 2,714,066, 3,181,461, 3,280,734 and 3,902,734. In this method, the support is immersed or electrolyzed in an aqueous sodium silicate solution. In addition, a method of treating the support with potassium fluorozirconate described in JP-B-36-22063 and a method of treating the support with polyvinylphosphonic acid described in U.S. Patents 3,276,868, 4,153,461 and 4,689,272 can be used.

### (Other treatments (washing with water and sealing))

After the completion of each treatment, squeezing of solution through a nip roller and washing with water by means of a spray are performed so as not to carry over the treatment solution to the next step. It is preferred to conduct a sealing treatment after the anodizing treatment. The sealing treatment is conducted by immersion in hot water or hot aqueous solution containing an inorganic salt or organic salt or by a steam bath.

### [Formation of backcoat layer]

In the backcoat layer coating and drying section, on the back surface of the support is provided, if desired, a coating layer (hereinafter, the coating layer is referred to as a backcoat layer) comprising an organic polymer compound so as to prevent scratching of the photosensitive composition layer when the photosensitive lithographic printing plates are piled. As the main component of the backcoat layer, at least one resin having a glass transition point of 20°C or higher selected from an saturated copolymerization polyester resin, a phenoxy resin, a polyvinyl acetal resin and a vinylidene chloride copolymerization resin is used. The saturated copolymerization polyester resin comprises a dicarboxylic acid unit and a diol unit. Examples of the dicarboxylic acid unit of the polyester resin for use in the invention include an aromatic dicarboxylic acid, for example, phthalic acid, terephthalic acid, isophthalic acid, tetrabromophthalic acid or tetrachlorophthalic acid, and a saturated aliphatic dicarboxylic acid, for example, adipic acid, azelaic acid, succinic acid, oxalic acid, suberic acid, cebacic acid, malonic acid or 1,4-cyclohexanedicarboxylic acid. To the backcoat layer may further appropriately added a dye or pigment for coloration, a silane coupling agent, a diazo resin comprising a diazonium salt, an organic phosphonic acid, an organic phosphoric acid or a cationic polymer for improving an adhesion property to the aluminum support, or as a lubricant, a conventionally used wax, a higher fatty acid, a higher fatty acid amide, a silicone compound comprising dimethylsiloxane, a modified dimethylsiloxane or polyethylene powder. The thickness of the backcoat layer is basically thickness for preventing scratching without an interleaf and is preferably in a range of 0.01 to 8 µm. In order to coat the backcoat layer on the back surface of the support, various methods can be utilized. For instance, a method wherein a solution prepared by dissolving the components in an appropriate solvent or an emulsion dispersion of the components is coated (applied) and dried, a method wherein the backcoat layer previously cast on a film is laminated on the support with adhesive or heat or a method wherein a molten film is formed by a melt extruder and laminated on the support is exemplified and the method wherein a solution prepared by dissolving the components and coated is most preferable in view of ensuring the above-described coating amount. As the solvent used, organic solvents as described in JP-A-62-251739 are used individually or in combination. As for the coating method and conditions, many of the coating methods and conditions for the photosensitive composition layer described hereinafter can be utilized. Specifically, a method of using a coating rod, a method of using an extrusion type coater or a method of using a slide bead coater can be utilized. As for the conditions for coating, physical properties of the coating solution and the like, those described for the photosensitive composition layer can also utilized.

### [Undercoat layer]

In the undercoat layer coating and drying section, an undercoat layer is formed by coating (applying) a coating solution for undercoat layer on the surface of the support and drying, if desired. In the undercoat layer coating and drying section, many of the coating methods and conditions for the photosensitive composition layer described hereinafter can also be utilized. Specifically, a method of using a coating rod, a method of using an extrusion type coater or a method of using a slide bead coater can be utilized. As for the conditions for coating, physical properties of the coating solution and the like, those described for the photosensitive composition layer can also utilized.

As the undercoat layer according to the invention, an organic undercoat layer is preferable. A sol gel treatment forming a covalent bond of a functional group capable of causing an addition reaction with a radical as described in JP-A-7-159983 may also be provided.

As the material for forming the organic undercoat layer, a water-soluble resin, for example, polyvinylphosphonic acid, a polymer or copolymer having a sulfonic acid group in its side chain, polyacrylic acid, carboxymethyl cellulose, dextrin or gum arabic, and a low molecular weight organic compound, for example, a phosphonic acid having an amino group (for example, 2-aminoethylphosphonic acid), an organic phosphonic acid (for example, phenylphosphonic acid, naphthylphosphonic acid, alkylphosphonic acid, glycerophosphonic acid, methylenediphosphonic acid or ethylenediphosphonic acid, each of which may have a substituent), an organic phosphoric acid (for example, phenylphosphoric acid, naphthylphosphoric acid, alkylphosphoric acid or glycerophosphoric acid, each of which may be substituted), an organic phosphinic acid (for example, phenylphosphinic acid, naphthylphosphinic acid, alkylphosphinic acid or glycerophosphinic acid, each of which may be substituted), an amino acid (for example, glycine or β-alanine), a hydrochloride of an amine containing a hydroxy group (for example, triethanolamine hydrochloride), a water-soluble metal salt (for example, zinc borate), a yellow dye or an amine salt are exemplified. The organic compounds may be used individually or as a mixture of two or more thereof.

The organic undercoat layer can be provided in the following manner. Specifically, the organic compound described above is dissolved in water, an organic solvent, for example, methanol, ethanol or methyl ethyl ketone, or a mixture thereof, and the solution thus prepared is coated on the support and dried to form the organic undercoat layer. Alternatively, the organic compound described above is dissolved in water, an organic solvent, for example, methanol, ethanol or methyl ethyl ketone, or a mixture thereof, and the support is immersed in the solution thus prepared to adsorb the organic compound on the surface of support, then washed, for example, with water and dried to form the organic undercoat layer. According to the former method, the solution of the organic compound in concentration of 0.005 to 10% by weight can be coated by a variety of methods. Any method including, for example, bar coater coating, spin coating, spray coating or curtain coating can be employed. In the latter method, the concentration of the organic compound in the solution is ordinarily from 0.01 to 20% by weight, and preferably from 0.05 to 5% by weight. The immersion temperature is ordinarily from 20 to 90°C, and preferably from 25 to 50°C. The immersion time is ordinarily from 0.1 second to 20 minutes, and preferably from 2 seconds to one minute.

The solution for undercoat layer may be used by adjusting the pH thereof in a range of 1 to 12 with a basic substance, for example, ammonia, triethylamine or potassium hydroxide, or an acidic substance, for example, hydrochloric acid or phosphoric acid. Further, in order to improve tone reproducibility of the photopolymerization type photosensitive lithographic printing plate, a yellow dye may be added to the undercoat layer.

The coverage of the undercoat layer after drying is preferably from 2 to 200 mg/m², and more preferably from 5 to 100 mg/m². When the coverage is less than 2 mg/m², sufficient printing durability may not be obtained and whereas, when it is more than 200 mg/m², sufficient printing durability also may not be obtained.

### [Formation of Photosensitive layer]

In the photosensitive layer coating (applying) and drying section, a solution for the photopolymerization type photosensitive composition is coated (applied) and dried to form a photopolymerizable photosensitive layer.

As a solvent for dissolving the photopolymerization type photosensitive composition, organic solvents described in JP-A-62-251739 or JP-A-6-242597 can be used. The photopolymerization type photosensitive composition is dissolved or dispersed at a solid content concentration of 2 to 50% by weight and coated (applied) and dried. Although the coating amount of the layer of the photopolymerization type photosensitive composition (photosensitive layer) may be varied depending on the use, in general, it is preferably from 0.3 to 4.0 g/m², in terms of weight after drying. As the coating amount decreases, the exposure amount for obtaining the image becomes smaller, but the layer strength decreases. On the other hand, as the coating amount increases, more exposure amount is required, but the exposed layer becomes stronger and, for example, when it is used as a printing plate, the printing plate exhibits a large number of sheets capable of being printed (high printing durability). To the photosensitive composition, a surfactant, particularly preferably, a fluorine-based surfactant, for improving surface quality of the coating can be added.

### (Photosensitive composition)

The photopolymerization type photosensitive composition constituting the photosensitive layer of the photosensitive lithographic printing plate for use in the invention comprises as the essential components, an addition-polymerizable compound having an ethylenically unsaturated double bond (hereinafter, also referred to as an ethylenically unsaturated compound), a photopolymerization initiator and an alkali-soluble or alkali-swellable binder (hereinafter, simply referred to as a binder). The photosensitive composition may further include various compounds, for example, a coloring agent, a plasticizer or a thermal polymerization inhibitor, if desired.

The ethylenically unsaturated compound is a compound including an ethylenically unsaturated bond which undergoes addition polymerization upon the function of the photopolymerization initiator to cause crosslinking or curing, when the photopolymerization type photosensitive composition is irradiated with an active ray.

The ethylenically unsaturated compound is appropriately selected from compounds including at least two terminal ethylenically unsaturated bonds. Compound including four or more terminal ethylenically unsaturated bonds are more preferable.

The ethylenically unsaturated compound has a chemical form, for example, a monomer, a prepolymer, specifically, a dimer, a trimer or an oligomer, or a copolymer thereof, or a mixture thereof.

Examples of the monomer and copolymer thereof include esters of an unsaturated carboxylic acid (for example, acrylic acid, methacrylic acid, itaconic acid, crotonic acid, isocrotonic acid or maleic acid) with an aliphatic polyhydric alcohol compound and amides of an unsaturated carboxylic acid with an aliphatic polyvalent amine compound.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;
methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane or bis[p-(methacryldxyethoxy)phenyl]dimethylmethane;
itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate;
crotonic acid esters, for example, ethylene glycol dicrotonate, tetramethylene glycol dicrotonate, pentaerythritol dicrotonate or sorbitol tetradicrotonate;
isocrotonic acid esters, for example, ethylene glycol diisocrotonate, pentaerythritol diisocrotonate or sorbitol tetraisocrotonate;
and maleic acid esters, for example, ethylene glycol dimaleate, triethylene glycol dimaleate, pentaerythritol dimaleate and sorbitol tetramaleate.

Further, mixtures of the above-described ester monomers can also be exemplified.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

As other examples, vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R⁵)COOCH₂CH(R⁶)OH (A)

wherein R⁵ and R⁶ each independently represents H or CH₃.

Further, urethane acrylates as described in JP-A-51-37193 and JP-B-2-32293, polyfunctional acrylates and methacrylates, for example, polyester acrylates and epoxy acrylates obtained by reacting an epoxy resin with (meth)acrylic acid as described in JP-A-48-64183, JP-B-49-43191 and JP-B-52-30490 are exemplified. Moreover, photocurable monomers or oligomers described in Nippon Secchaku Kyokaishi (Journal of Japan Adhesion Society), Vol. 20, No. 7, pages 300 to 308 (1984) can also be used.

The amount of the ethylenically unsaturated compound used is ordinarily in a range of 5 to 80% by weight, preferably in a range of 30 to 70% by weight, based on the total components of the photosensitive layer.

Further, as the photopolymerization initiator incorporated into the photosensitive layer of the photosensitive lithographic printing plate according to the invention, various photopolymerization initiators known in patents and literatures or a combination system (photo-initiation system) of two or more photopolymerization initiators can be appropriately selected to use depending upon a wavelength of a light source employed. Specific examples thereof are illustrated below, but the invention should not be construed as being limited thereto.

Various photo-initiation systems have also been proposed for using visible light of 400 nm or longer, an Ar laser, second harmonic of a semiconductor laser, an SHG-YAG laser or a solid laser or semiconductor laser emitting an infrared ray having a wavelength of 760 to 1,200 nm as the light source. For instance, there are illustrated a certain kind of photo-reductive dyes (for example, Rose Bengal, Eosin or Erythrosine) described in U.S. Patent 2,850,445 and a system comprising a combination of a dye and an initiator, for example, a composite initiator system of a dye and an amine (JP-B-44-20189), a combined use of hexaarylbiimidazole, a radical generator and a dye (JP-B-45-37377), a system of hexaarylbiimidazole and p-dialkylaminobenzylidene ketone (JP-B-47-2528 and JP-A-54-155292), a system of a cyclic cis-α-dicarbonyl compound and a dye (JP-A-48-84183), a system of a cyclic triazine and a merocyanine dye (JP-A-54-151024), a system of 3-ketocoumarin and an active agent (JP-A-52-112681 and JP-A-58-15503), a system of biimidazole, a styrene derivative and thiol (JP-A-59-140203), a system of an organic peroxide and a dye (JP-A-59-1504, JP-A-59-140203, JP-A-59-189340, JP-A-62-174203, JP-B-62-1641 and U.S. Patent 4,766,055), a system of a dye and an active halogen compound (JP-A-63-258903 and JP-A-2-63054), a system of a dye and a borate compound (JP-A-62-143044, JP-A-62-150242, JP-A-69-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing dye and a radical generator (JP-A-2-179643 and JP-A-2-244050), a system of titanocene and a 3-ketocoumarin dye (JP-A-63-221110), a system wherein titanocene is combined with a xanthene dye and, further, an amino group- or urethane group-containing addition-polymerizable ethylenically unsaturated bond-containing compound (JP-A-4-221958 and JP-A-4-219756), a system of titanocene and a specific merocyanine dye (JP-A-6-295061) and a system of titanocene and a benzopyran ring-containing dye (JP-A-8-334897).

Recently, a laser (violet laser) emitting light having a wavelength of 400 to 410 nm has been developed, and a photo-initiation system exhibiting high sensitivity to light having a wavelength of 450 nm or shorter has been developed. Such a photo-initiation system can also be employed.

For example, a cation dye/borate system (JP-A-11-84647), a merocyanine dye/titanocene system (JP-A-2000-147763) and a carbazole type dye/titanocene system (JP-A-2001-42524) are exemplified.

According to the invention, a system using a titanocene compound and/or a hexaarylbiimidazole compound is particularly preferred because the system is excellent in sensitivity. Further, a system using a hexaarylbiimidazole compound is most preferred from the standpoint of the sensitivity and preservation stability.

It is preferred to add a sensitizing dye to the photo-initiation system in addition to the photopolymerization initiator according to the invention. As the sensitizing dye, various dyes known in patents and literatures having sensitivity to a light source, for example, an ultraviolet ray, visible light, an Ar ion laser, an FD-YAG laser or a short wavelength semiconductor laser can be appropriately selected to use. For instance, there are illustrated a certain kind of photo-reductive dyes described in U.S. Patent 2,850,445, dialkylaminobenzylidene ketone dyes described in JP-B-47-2528, merocyanine dyes described in JP-A-54-151024, 3-ketocoumarin dyes described in JP-A-58-15503, cyanine dyes and merocyanine dyes described in JP-A-59-140203, JP-A-62-174203 and JP-A-2-63054, rhodanine skeleton-containing dyes described in JP-A-2-244050, xanthene dyes described in JP-A-4-219756, merocyanine dyes described in JP-A-6-295061, benzopyran ring-containing dyes described in JP-A-8-334897 and sensitizing dyes described in B. M. Monroe, Chemical Review, Vol. 93, pages 435 to 448 (1993) and D. F. Eaton, Advance in Photochemistry, Vol. 13, pages 427 to 480 (1986). As particularly useful dyes, dye highly sensitive to light of 350 to 450 nm, for example, merocyanine dyes described in JP-A-2000-147763, carbazole type dyes described in JP-A-2001-42524, merocyanine dyes described in JP-A-2003-21895 and oxazolidinone skeleton dyes merocyanine dyes described in JP-A-2003-221517.

The method of using the sensitizing dye can also be appropriately arranged depending on the characteristic design of the final photosensitive material similar to the above-described addition-polymerizable compound. For instance, when two or more sensitizing dyes are used in combination, the compatibility with the photosensitive layer can be enhanced. For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small, and is also advantageous in view of the physical properties of the photosensitive layer. Since the photosensitivity and resolution of the photosensitive layer and the physical properties of the exposed area of the photosensitive layer are greatly influenced by the absorbance of sensitizing dye at the wavelength of light source, the amount of the sensitizing dye added is appropriately selected in consideration of these factors. For instance, in a low absorbance region of the photosensitive layer of 0.1 or less, the sensitivity decreases. Also, the resolution decreases due to the influence of halation. However, for the purpose of curing a layer having a large thickness, for example, of 5 µm or more, such low absorbance is sometimes rather effective for increasing the curing degree. On the other hand, in a high absorbance region of 3 or more, the light is mostly absorbed on the surface of the photosensitive layer to inhibit curing of the inner part and as a result, for example, when a printing plate is produced, the layer strength and the adhesion property to a substrate become insufficient.

In the case of using in a photosensitive layer having a relatively small thickness of the lithographic printing plate precursor, the amount of the sensitizing dye added is preferably selected such that the photosensitive layer has absorbance of 0.1 to 3.0, more preferably from 0.25 to 1.5. In the case of utilizing as the lithographic printing plate precursor, the amount of the sensitizing dye is ordinarily from 0.05 to 30 parts by weight, preferably from 0.1 to 20 parts by weight, more preferably from 0.2 to 10 parts by weight, per 100 parts by weight of the total components constituting the photosensitive layer.

The sensitizing dye for use in the invention is a laser light-absorbing dye (sensitizing dye) having an absorption maximum wavelength in a range of 330 to 430 nm.

For example, in the case of using as the light source, light of around 400 nm, benzyl, benzoyl ether, Michler's ketone, anthraquinone, thioxantone, acridine, phenazine, benzophenone and the like can be used.

Also, in the case of using as the light source, light having 330 nm or longer, an Ar laser, second harmonic of a semiconductor laser or an SHG-YAG laser, various photo-initiation systems have been proposed. For instance, there are illustrated a certain kind of photo-reductive dyes (for example, Rose Bengal, Eosin or Erythrosine) described in U.S. Patent 2,850,445 and a system comprising a combination of a dye and an initiator, for example, a composite initiator system of a dye and an amine (JP-B-44-20189), a combined use of hexaarylbiimidazole, a radical generator and a dye (JP-B-45-37377), a system of hexaarylbiimidazole and p-dialkylaminobenzylidene ketone (JP-B-47-2528 and JP-A-54-155292), a system of a cyclic cis-α-dicarbonyl compound and a dye (JP-A-48-84183), a system of a cyclic triazine and a merocyanine dye (JP-A-54-151024), a system of 3-ketocoumarin and an active agent (JP-A-52-112681 and JP-A-58-15503), a system of biimidazole, a styrene derivative and thiol (JP-A-59-140203), a system of an organic peroxide and a dye (JP-A-59-1504, JP-A-59-140203, JP-A-59-189340, JP-A-62-174203, JP-B-62-1641 and U.S. Patent 4,766,055), a system of a dye and an active halogen compound (JP-A-63-1780105, JP-A-63-258903 and JP-A-2-63054), a system of a dye and a borate compound (JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing dye and a radical generator (JP-A-2-179643 and JP-A-2-244050), a system of titanocene and a 3-ketocoumarin dye (JP-A-63-221110), a system wherein titanocene is combined with a xanthene dye and, further, an amino group- or urethane group-containing addition-polymerizable ethylenically unsaturated bond-containing compound (JP-A-4-221958 and JP-A-4-219756), a system of titanocene and a specific merocyanine dye (JP-A-6-295061) and a system of titanocene and a benzopyran ring-containing dye (JP-A-8-334897).

As the laser light-absorbing dye (sensitizing dye), a dye having absorption wavelength in a short wavelength range of 330 to 430 nm is preferably used.

As the laser light-absorbing dye for use in the invention, dyes conventionally known as sensitizing dyes for laser exposure are used. For example, triazole type sensitizing dyes described in JP-A-2003-221517 are exemplified.

The sensitizing dye preferably used in the invention includes the compounds represented by the following formula (1) :

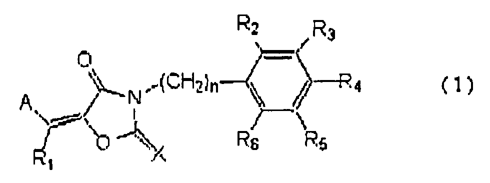

In formula (1), A represents an aromatic cyclic group which may have a substituent or a heterocyclic group which may have a substituent, X represents an oxygen atom, a sulfur atom or NR₇, R₁, R₂, R₃, R₄, R₅, R₆ and R₇ each independently represents a hydrogen atom or a monovalent non-metallic atomic group, provided that at least one of R₂, R₃, R₄, R₅ and R₆ represents a substituent represented by -OR₈, R₈ represents a monovalent non-metallic atomic group, and n represents an integer of 1 to 6.

The formula (1) is described in detail below.

The monovalent non-metallic atomic group represented by any one of R₁, R₂, R₃, R₄, R₅, R₆, R₇ and R₈ (hereinafter, abbreviated as R₁ to R₈ in sometimes) preferably includes a substituted or unsubstituted alkyl group, a substituted or unsubstituted alkenyl group, a substituted or unsubstituted aryl group, a substituted or unsubstituted heterocyclic group, a substituted or unsubstituted alkynyl group, a substituted or unsubstituted alkoxy group, a substituted or unsubstituted alkylthio group, a hydroxy group, an acyl group and a halogen atom.

Further, it is known that the photo-initiation ability is moreover enhanced by adding to the above-described photopolymerization initiator, a hydrogen donating compound, for example, a thiol compound (e.g., 2-mercaptobenzothiazole, 2-mercaptobenzimidazole or 2-mercaptobenzoxazole), N-phenylglycine, N,N-dialkylamino aromatic alkyl ester, 2-methyl-1-[4-(methylthio)phenyl]-2-piperizinopropan-1-one or oxime ether compounds described, for example, in JP-A-8-202035 and JP-A-10-237118, if desired.

The amount of the photopolymerization initiator (system) used is ordinarily from 0.05 to 100 parts by weight, preferably from 0.1 to 70 parts by weight, more preferably from 0.2 to 50 parts by weight, per 100 parts by weight of the ethylenically unsaturated compound.

Since the binder for use in the photosensitive layer of the photosensitive lithographic printing plate according to the invention not only functions as a film-forming agent of the photosensitive layer but also is required to be dissolved in an alkali developer, an organic polymer soluble or swellable in alkali water is used.

For example, when a water-soluble organic polymer is used as the organic polymer, water development is capable of being performed. Examples of such an organic polymer include addition polymers having a carboxylic acid group in the side chain thereof, for example, polymers described in JP-A-59-44615, JP-B-54-34327, JP-B-58-12577, JP-B-54-25957, JP-A-54-92723, JP-A-59-53836 and JP-A-59-71048, more specifically, methacrylic acid copolymers, acrylic acid copolymers, itaconic acid copolymers, crotonic acid copolymers, maleic acid copolymers and partially esterified maleic acid copolymers.

Also, acidic cellulose derivatives having a carboxylic acid group in the side chain thereof is exemplified. Further, polymers obtained by adding a cyclic acid anhydride to an addition polymer having a hydroxy group and the like are useful. Among them, copolymers of benzyl (meth)acrylate, (meth) acrylic acid and, if desired, other addition-polymerizable vinyl monomer and copolymers of allyl (meth)acrylate, (meth)acrylic acid and, if desired, other addition-polymerizable vinyl monomer are preferable. In addition, polyvinyl pyrrolidone, polyethylene oxide and the like are preferable as the water-soluble organic polymer. Moreover, in order to increase strength of the cured layer, alcohol-soluble polyamides, polyethers of 2,2-bis-(4-hydroxyphenyl)propane with epichlorohydrin and the like are also useful.

Furthermore, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful in the invention.

By introducing a radical crosslinkable group into the side chain of the polymer, the strength of the cured layer can be increased. The crosslinkable group means a group capable of crosslinking the polymer binder in the process of a radical polymerization reaction which is caused in the photosensitive layer, when the photosensitive lithographic printing plate is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and a functional group, for example, a (meth)acryl group, an allyl group or a styryl group is particularly preferable.

In order to maintain the developing property of the photosensitive layer, it is preferred that the binder polymer used has an appropriate molecular weight and acid value. A polymer having a weight average molecular weight of 5, 000 to 300,000 and an acid value of 20 to 200 is preferably used.

The organic polymer can be incorporated into the photosensitive layer in an appropriate amount. However, preferable results may not be achieved in view of strength or the like of the image formed when the amount of the organic polymer exceeds 90% by weigh of the total amount of the photosensitive layer. The amount of the organic polymer is preferably from 10 to 90% by weight, more preferably from 30 to 80% by weight, based on the total amount of the photosensitive layer. Also, the ratio of the photopolymerizable ethylenically unsaturated compound to the organic polymer is preferably in a range of 1/9 to 9/1, more preferably in a range of 2/8 to 8/2, still more preferably in a range of 3/7 to 7/3, in terms of weight ratio.

Also, in the invention, it is preferred to add a small amount of a thermal polymerization inhibitor in addition to the above-described essential components, in order to prevent the polymerizable ethylenically unsaturated compound from undergoing undesirable thermal polymerization during the production or preservation of the photosensitive layer. Suitable examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxylamine aluminum salt. The amount of the thermal polymerization inhibitor added is preferably from about 0.01 to about 5% by weight based on the total weight of the photosensitive layer. If desired, in order to prevent polymerization inhibition due to oxygen, a higher fatty acid derivative, for example, behenic acid or behenic amide may be added and allowed to localize on the surface of the photosensitive layer during the drying step after the coating thereof. The amount of the higher fatty acid derivative added is preferably from about 0.5 to about 10% by weight based on the total weight of the photosensitive layer.

Further, for the purpose of coloring the photosensitive layer, a coloring agent may be added. Examples of the coloring agent include pigments, for example, phthalocyanine pigments (e.g.,, C.I. Pigment Blue 15:3, C.I. Pigment Blue 15:4 or C.I. Pigment Blue 15:6), azo pigments, carbon black or titanium oxide, Ethyl Violet, Crystal Violet, azo dyes, anthraquinone dyes and cyanine dyes. The amount of the coloring agent added is preferably from about 0.5 to about 20% by weight of the total weight of the photosensitive layer.

In addition, for the purpose of improving physical properties of the cured film, an additive, for example, an inorganic filler or a plasticizer (for example, dioctyl phthalate, dimethyl phthalate or tricresyl phosphate) may be added. The amount of the additive added is preferably 10% by weight or less of the total weight of the composition.

At the coating of the photosensitive layer composition on a support, it is used by dissolving in a variety of solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate and ethyl lactate. The solvents may be used individually or as a mixture thereof. The concentration of solid content in the coating solution is appropriately from 1 to 50% by weight.

A surfactant may be added to the photopolymerizable composition for the photosensitive layer of the photosensitive lithographic printing plate according to the invention in order to improve surface quality of coating. The coverage of the photosensitive layer is preferably in a range of about 0.1 to about 10 g/m², preferably in a range of 0.3 to 5 g/m², and more preferably in a range of 0.5 to 3 g/m², in terms of weight after drying.

### (Coating method)

As the coating (applying) method of the photosensitive composition, for example, a method of using a coating rod described in JP-B-58-4589 and JP-A-59-123568, a method of using an extrusion coater described in JP-A-4-244265 or a method of using a slide bead coater described in JP-B-1-57629 and JP-A-10-128212 can be employed, but the invention should not be construed as being limited thereto. Several methods are described in detail below.

### (1) Rod coating method

The coating method using a coating rod is a method wherein the coating rod is brought into contact with a running support to achieve a prescribed coating amount. The coating method using a coating rod is a method wherein the coating rod includes a method wherein one coating rod has both a function of transferring a coating solution to a support to coat and a function of controlling an amount of the coating solution and a method wherein a coating solution previously coated excessively on a support is scratched by a coating rod to control an amount of the coating solution. In the former case, the coating solution is supplied so as to form a puddle of the coating solution just before the position at which the coating rod is brought into contact with the support and an coating amount is controlled by the coating rod to achieve the desired coating amount.

In the coating method using a coating rod, the coating rod can be stand still or can be rotated at an appropriate peripheral velocity in the forward direction or reverse direction to the running direction of the support. In such a case, the coating rod may be forcibly rotated by a method, for example, using an external drive unit or passively rotated by the contact with the running support.

A flap angle of the support to the coating rod is preferably in a range of 1 to 30 degrees, and more preferably from 2 to 20 degrees.

With respect to the physical properties of the coating solution, the viscosity is preferably 100 cp or less, more preferably 50 cp or less, and the surface tension is preferably in a range of 20 to 70 dyne/cm.

According to the coating method, the coating amount is controlled by a size of groove on the surface of the coating rod or a size of wire in case of a wire rod in which a wire is wound around the rod. Although the controlling range of the coating amount is not clearly restricted, it is ordinarily from 3 to 100 cc/m². The diameter of the coating rod is also not particularly restricted and ordinarily from 6 to 25 mm, and preferably from 6 to 15 mm. As the material of the rod, metal is preferable and stainless steel is particularly suitable in view of corrosion resistance and strength.

The coating rod for use in the invention includes, for example, a wire rod on which a wire is densely wound around the rod in the circumferential direction to form a groove between the adjacent wires or a carved rod on which grooves are formed in the circumferential direction over the whole length of the rod or in the desired portion of the rod.

When the wire rod is used, an appropriate diameter of the wire is suitably from 0.07 to 1.0 mm, and preferably from 0.07 to 0. 6 mm. As the material of the wire, metal is used and stainless copper is most suitable in view of corrosion resistance, abrasion resistance, strength and the like. The wire rod is subjected to plating on the surface thereof in order to more improve the abrasion resistance. Particularly, hard chromium plating is suitable.

When the carved rod is used in the invention, a pitch of the grooves is suitably from 0.05 to 1.0 mm, and preferably from 0.1 to 0.6 mm, and the cross-sectional shape is suitably a shape closely related to a sine curve or a trapezoidal shape. However, the cross-sectional shape is not necessarily restricted to those described above and the carved rod of other cross-sectional shape can be used. The carved rod is subjected to plating on the surface thereof in order to more improve the abrasion resistance. Particularly, hard chromium plating is suitable.

As a rod support member, a material having a small friction resistance between the rod (wire in the wire rod) and the rod support member should be selected because the rod rotates at high speed. As the material of the rod support member and weir member for use in the invention, for example, a fluorine resin, a polyacetal resin or a polyethylene resin is exemplified. Among them, polytetrafluoroethylene known as Teflon (registered trademark) and a polyacetal resin known as Derlin (trade mark of DuPont, USA) are particularly preferable in view of the friction coefficient and strength. A plastic material to which filler, for example, glass fiber, graphite or molybdenum disulfide is also used. Further, the rod support member is produced by a metal material and coated or laminated with the plastic material as described above to reduce the friction coefficient between the rod and the rod support member. Alternatively, various metal materials impregnated with the plastic material as described above, for example, aluminum impregnated with polytetrafluoroethylene are used as the rod support member.

### (2) Extrusion coating method

As another method, a coating method wherein a coating solution is discharged from an extrusion type injector to form a coating solution bead between the extrusion type injector and a support run wound by a backup roller and the back side of the coating solution bead is depressurized or the front side of the coating solution bead is pressurized to perform coating can be used. According to the method, the solution can be coated in an amount from about 10 to about 500 cc/m² although the amount depends on the clearance between the support and the tip of the injector. With respect to the physical properties of the coating solution, the viscosity is preferably in a range of 0.7 to 100 cp and the surface tension is preferably in a range of 20 to 50 dyne/cm. The clearance between the support and the tip of the injector is ordinarily from about 0.1 to about 0.5 mm.

### (3) Slide coating method

As still another method, a coating method wherein a coating solution is flowed down in the form of liquid film on the surface of a slide to form a coating solution bead in the clearance where the coating solution meets a running support at the end of the surface of slide and the coating solution is coated through the bead on the support can be used. If desired, the back side of the coating solution bead is depressurized or the front side of the coating solution bead is pressurized to perform the coating. According to the method, the solution can be coated in an amount from about 10 to about 100 cc/m², With respect to the physical properties of the coating solution, the viscosity is preferably in a range of 1 to 200 cp and the surface tension is preferably in a range of 20 to 60 dyne/cm. The clearance between the support and the end of the surface of slide is ordinarily from about 0.1 to about 0.6 mm.

### (Drying method)

Now, the drying method is described below. As the drying method, a method wherein pass rolls are arranged in a drying apparatus and while transporting a support by wrapping with the pass rolls, hot air is blown to dry described in JP-A-6-63487, a method wherein air is supplied from nozzles on the upper surface and lower surface of a support and while floating the support, the support is dried, a method wherein radiant heat emitted from heating plates positioned on the upper side and lower side of a support is used to dry described in JP-A-60-149841, or a method wherein heat medium is introduced through a roll to heat the roll and heat conduction by contacting the roll with a support is used to dry described in JP-A-60-21334 is exemplified.

In any method, in order to uniformly dry a web coated the coating solution on the support, control of the heating is conducted by appropriately changing an amount, temperature or supplying method of the hot air or heat medium depending on kinds of the support and photosensitive composition, coating amount, kind of the solvent, running speed or the like. Also, two or more kinds of the drying methods may be used in combination.

### (1) Hot air drying method

As the method of supplying the hot air in the hot air drying method, for example, a method of supplying hot air in the same direction or in the opposite direction of the running direction of the support along the running direction of the support, a method of blowing hot air on the upper side of the support from slit nozzles multiply arranged in the perpendicular direction to the running direction of the support or a method of supplying hot air of low speed through a punching metal on the upper side of the support is exemplified.

These methods may be used individually or in combination of two or more thereof depending on the kinds of the support and photosensitive composition, coating amount, kind of the solvent, running speed or the like. Further, the hot air supplying method may be varied at the position in the drying apparatus, for example, at initial stage, middle stage or late stage.

Further, in the method supplying the hot air along the running direction of the support, the hot air speed along the support is preferably in a range of 0.3 to 8 m/sec. In the method of using the slot nozzle, it is preferred that the hot air blowing speed from the nozzle is in a range of 3 to 15 m/sec and the distance from the nozzle to the support is in a range of 5 to 200 mm. In the method using the punching metal, the hot air speed on the support is preferably 2 m/sec or less.

In any method, it is preferred that the temperature of hot air is selected in a range of 40 to 170°C and the dew point of hot air is selected in a range of -5 to 25°C, but they can be appropriately selected depending on the kinds of the support and photosensitive composition, coating amount, kind of the solvent, running speed or the like. Also, the temperature, dew point and speed of the hot air may be varied at the position in the drying apparatus, for example, at initial stage, middle stage or late stage.

### (2) Heat roll method

In the method wherein heat medium is introduced through a roll to heat the roll and heat conduction by contacting the roll with a support is used to dry, the temperature of the roll introduced the heat medium and the time for contacting the roll with the support are appropriately selected so as to obtain the desired drying condition depending on the kinds of the support and photosensitive composition, coating amount, kind of the solvent, running speed or the like. As the heat medium for the roll, for example, oil, molten metal or heated water vapor is preferably used.

### [Formation of overcoat layer]

In the overcoat layer coating and drying section, on the photosensitive layer is coated a coating solution for oxygen blocking overcoat layer by a coater. As the coater and a drying apparatus, those using for forming the undercoat layer or the photosensitive layer can be used. With respect to the drying apparatus, however, the hot air drying method is preferably used.

According to the invention, after forming the overcoat layer on the photosensitive by coating a coating solution for overcoat layer using a coater, at least one of the drying conditions of the temperature, speed and dew point of the drying air and the drying time in the hot air drying apparatus is controlled so as to make the crystallization degree of the overcoat layer of 0.2 to 0.5. By controlling the crystallization degree of a water-soluble polymer compound in the overcoat layer, properties influenced on the quality of the photosensitive lithographic printing plate, for example, the stability of sensitivity and printing durability, remaining layer failure or transporting ability in a setter can be improved. When the crystallization degree is less than 0.2, the transporting ability in a setter, fine layer losing failure and fine remaining layer failure may not be improved and whereas, when it exceeds 0.5, the stability of sensitivity and printing durability and development failure, for example, remaining layer or remaining color may not be improved.

Examples of the water-soluble polymer incorporated into the overcoat layer include polyvinyl alcohol, a partial ester, ether or acetal thereof and a copolymer thereof containing a substantial amount of an unsubstituted vinyl alcohol unit necessary for providing the water-solubility. Examples of the polyvinyl alcohol include those having a hydrolysis ratio of 71 to 100% by mole and a polymerization degree in a range of 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all of which are manufactured by Kuraray Co., Ltd., are enumerated. The copolymer includes polyvinyl acetate, chloroacetate or propionate, polyvinyl formal and polyvinyl acetal hydrolyzed to an extent of 88 to 100% and copolymers thereof. Other useful polymers include, for example, polyvinyl pyrrolidone, gelatin and gum arabic. The polymers may be used individually or in combination. The content of the water-soluble polymer is ordinarily from 30 to 99% by weight, preferably from 50 to 99% by weight, based on the total solid content of the overcoat layer.

To the overcoat layer may be added known additives, for example, a surfactant for improving coating property or a water-soluble plasticizer for improving physical property of the coated layer. Examples of the water-soluble plasticizer include propionamide, cyclohexanediol, glycerin and sorbitol. Also, a water-soluble (meth) acrylic polymer may be added. The coverage of the additives is preferably from about 0.1 to about 15 g/m², more preferably from 1.0 to about 5 g/m², in terms of weight after drying. The drying coating amount of the overcoat layer is ordinarily from 0.5 to 10 g/m², preferably from 1.0 to 5.0 g/m².

### [Heat treatment]

The method for preparation of a photosensitive lithographic printing plate is characterized by including the step of conducting heat treatment of the photosensitive lithographic printing plate having the coated and dried photopolymerizable photosensitive layer at a temperature of 30 to 60°C. By conducting the heat treatment, the photosensitive lithographic printing plate having the stable sensitivity, high sensitivity and high printing durability can be obtained.

The heat treatment is preferably conducted after the formation of the overcoat layer in view of the production efficiency.

Although the range of the effective heat treatment conditions for achieving the stable sensitivity region may vary depending on the cases, it can be easily determined by trial and error.

The phase separation of the photosensitive layer is accelerated by an appropriate heat treatment.

When the heat treatment is conducted at a low temperature of less than 30°C, a long period of time is required for the stabilization of sensitivity. On the other hand, when the heat treatment is conducted at a high temperature exceeding 60°C, the sensitivity adversely becomes unstable due to the influences, for example, of decomposition of the photosensitive layer composition or dark polymerization by radical occurred based on the decomposition. Therefore, it is desired that the heat treatment is conducted in a temperature range of 30 to 60°C, preferably in a temperature range of 35 to 50°C.

The period of time for the heat treatment can also be determined by trial and error. In general, when the heat treatment temperature is low, the period of time for the heat treatment becomes long. However, in all cases, it is desired to conduct the heat treatment for at least 5 days, more preferably for at least 10 days.

The heat treatment can be conducted in the state of a roll made by rolling up of the master of photosensitive lithographic printing plate, in the state of a sheet after cutting or in the state of laminate of sheets stacked. It is preferably conducted in the state of a sheet.

### [Rolling up of master of photosensitive lithographic printing plate]

The master of photosensitive lithographic printing plate prepared is once rolled up in the state of a roll on a winder. By rolling up once the master of photosensitive lithographic printing plate on the winder, time lapse of a coil between the production of a long master of photosensitive lithographic printing plate and a sheet process step for cutting the master into a product size can be prolonged so that flexibility can increase in comparison with a production method wherein the preparation and the sheet process are continuously conducted, whereby the productivity can be increased. By the rolling up of the master, it is necessary to rewind the master roll to transport to the sheet process step and at this time there is fear of peeling of the overcoat layer from the photosensitive layer. However, since the adhesion property between the overcoat layer and the photosensitive layer can be increased by controlling the crystallization degree of the overcoat layer to 0.2 to 0.5 according to the invention, there is no possibility of peeling of the overcoat layer from the photosensitive layer when the master roll is rewound to transport to the sheet process step.

### [Sheet process of master of photosensitive lithographic printing plate]

In the sheet process step, after attaching a protective sheet (interleaf) on the overcoat layer, the photosensitive lithographic printing plate is cut lengthwise and crosswise by a lengthwise cutting machine and a crosswise cutting machine respectively. In this case, it is preferred to provide an interleaf moisture adjustment device capable of controlling temperature and humidity in order to adjust the moisture content of the interleaf to 2 to 10% by weight, preferably to 4 to 6.5% by weight. The change of the moisture content of the overcoat layer is prevented by attaching the interleaf to the photosensitive lithographic printing plate. Thus, since it is prevented to depart the moisture content of the overcoat layer from the range of 2 to 8% by weight in the sheet process step, the good quality of the photosensitive lithographic printing plate after the preparation can be maintained. The moisture content of the interleaf can be continuously measured by using an infrared detector.

### [Exposure and development of photosensitive lithographic printing plate]

A product of the photosensitive lithographic printing plate undergoing the sheet process is subjected to image exposure of the photosensitive layer, for example, with a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser, a semiconductor laser (wavelength of 350 to 600 nm) or a solid laser or semiconductor laser emitting an infrared ray (wavelength of 760 to 1,200 nm). After the image exposure with such an active ray conventionally known, the photosensitive lithographic printing plate is subjected to development processing to form an image on the surface of aluminum palate support.

Between the image exposure and development, the photosensitive lithographic printing plate may be subjected to a heat process at 50 to 150°C for one second to 5 minutes for the purpose of increasing the curing rate of the photopolymerizable photosensitive layer.

Since the overcoat layer having the oxygen blocking property is provided on the photosensitive layer of the photosensitive lithographic printing plate according to the invention as described above, a known method, for example, a method of removing both the overcoat layer and the unexposed area of the photosensitive layer at the same time using a developer or a method of first removing the overcoat layer with water or warm water, and then removing the unexposed area of the photosensitive layer by development can be used. Into the water or warm water may be incorporated an antiseptic described in JP-A-10-10754, an organic solvent described in JP-A-8-278636 or the like.

### [Developer]

The developer used for the plate-making method of the photosensitive lithographic printing plate according to the invention is not particularly limited but, for example, a solution containing an inorganic alkali salt and a nonionic surfactant and having a pH of 11.0 to 12.7 is preferably used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used independently or in combination of two or more thereof.

In the case of using a silicate, developing property can be easily adjusted by selecting a mixing ratio of silicon oxide (SiO₂) to alkali oxide (M₂O (wherein M represents an alkali metal or an ammonium group)), which are components of the silicate, and the concentration thereof. Of the alkali aqueous solutions, an alkali aqueous solution having the mixing ratio of silicon oxide (SiO₂) to alkali oxide (M₂O) (SiO₂/M₂O in molar ratio) of 0.5 to 3.0 is preferred, and that of 1.0 to 2.0 is more preferred. The total amount of SiO₂/M₂O in the alkali aqueous solution is preferably from 1 to 10% by weight, more preferably from 3 to 8% by weight, most preferably from 4 to 7% by weight, based on the weight of the alkali aqueous solution. When the concentration is 1% by weight or more, the developing property and processing ability are not decreased and whereas, when it is 10% by weight or less, the formation of precipitates and crystals is hard to occur and gelation at neutralization of waste liquor of the developer hardly occurs, thereby causing no troubles in treatment of the waste liquor.

Also, an organic alkali agent may be supplementarily used for the purpose of delicate adjustment of alkali concentration and assisting dissolution of the photosensitive layer. The organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used independently or in combination of two or more thereof.

The surfactant can be appropriately used. Examples thereof include nonionic surfactants, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glyceron monooleate); anionic surfactants, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, a compound having the structure represented by formula (12) shown below is preferably used.

R₄₀-O-(R₄₁-O)ₚH (I)

In formula (12), R₄₀ represents an alkyl group having from 3 to 15 carbon atoms, which may have a substituent, an aromatic hydrocarbon group having from 6 to 15 carbon atoms, which may have a substituent or a heteroaromatic cyclic group having from 4 to 15 carbon atoms, which may have a substituent. Examples of the substituent include an alkyl group having from 1 to 20 carbon atoms, a halogen atom, e.g., Br, cl or I, an aromatic hydrocarbon group having from 6 to 15 carbon atoms, an aralkyl group containing 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms, which may have a substituent. Examples of the substituent include an alkyl group having from 1 to 20 carbon atoms and an aromatic hydrocarbon group having from 6 to 15 carbon atoms. p represents an integer of 1 to 100.

In the definition of the formula (12), specific examples of "aromatic hydrocarbon group" include a phenyl group, a tolyl group, a naphthyl group, an anthryl group, a biphenyl group and a phenanthryl group, and specific examples of "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of (R₄₁-O)ₚ in the formula (12) may be two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used independently or in combination. The surfactant is effectively added in an amount from 1 to 30% by weight, preferably from 2 to 20% by weight, in the developer. When the amount of the surfactant is too small, deterioration of developing property may occur and whereas, it is too large, damage of the development increase and printing durability of printing plate degrades.

Examples of the nonionic surfactant having polyoxyalkylene ether group represented by formula (12) include a polyoxyethylene alkyl ether, e.g., polyoxyethylene lauryl ether, polyoxyethylene cetyl ether and polyoxyethylene stearyl ether; a polyoxyethylene aryl ether, e.g., polyoxyethylene phenyl ether and polyoxyethylene naphthyl ether; and a polyoxyethylene alkylaryl ether, e.g., polyoxyethylene methylphenyl ether, polyoxyethylene octylphenyl ether and polyoxyethylene nonylphenyl ether.

The surfactants can be used independently or in combination thereof. The content of the surfactant in the developer is preferably in a range of 0.1 to 20% by weight in terms of the active ingredient.

The pH of the developer for use in the plate-making of the photosensitive lithographic printing plate according to the invention is not particularly restricted and preferably from 11.0 to 12.7, more preferably from 11.5 to 12.5. When the pH of the developer is 11. 0 or more, the image-formation is surely conducted and whereas, when it is 12.7 or less, over development is prevented and the damage of the exposed area due to the development is restrained.

Further, the electric conductivity of the developer is preferably from 3 to 30 mS/cm. When the electric conductivity of the developer is 3 mS/cm or more, the dissolution of the photopolymerizable photosensitive layer on the surface of aluminum support is surely performed and whereas, when it is 30 mS/cm or less, it is prevented that a dissolution rate of the photopolymerizable photosensitive layer becomes extremely slow and the residual layer in the unexposed area does not occur. The electric conductivity is particularly preferably in a range from 5 to 20 mS/cm.

The development of the photosensitive lithographic printing plate according to the invention is conducted in a conventional manner at a temperature ordinarily from about 0 to about 60°C, preferably from about 15 to about 40°C, for example, by immersing the exposed photosensitive lithographic printing plate in the developer and rubbing with a brush.

Further, in the case of conducting the development processing using an automatic developing machine, the developer becomes fatigued in accordance with the processing amount, and hence the processing ability may be restored by using a replenishing solution or a fresh developer.

The thus development-processed photosensitive lithographic printing plate is subjected to after-treatment with washing water, a rinsing solution containing a surfactant or an oil-desensitizing solution containing gum arabic or a starch derivative as described in JP-A-54-8002, JP-A-55-115045 and JP-A-59-58431. In the after-treatment of the photosensitive lithographic printing plate according to the invention, these processings can be used in combination.

The lithographic printing plate thus-obtained by the above-described processing may be subjected to the after-exposing treatment described in JP-A-2000-89478 or a heat treatment, for example, baking, to improve printing durability.

The lithographic printing plate obtained by the processing is mounted on an offset printing machine to perform printing of a large number of sheets.

In the embodiment according to the invention, the master of the photosensitive lithographic printing plate is rolled up on a wider and then is rewound in the next sheet process step, but in the case wherein the preparation of the master and the sheet process are continuously conducted, the method for the production of the photosensitive lithographic printing plate according to the invention can also be employed.

### EXAMPLES

The present invention is described in more detail with reference to the following examples, but the invention should not be construed as being limited thereto.

### EXAMPLES 1 TO 3 AND COMPARATIVE EXAMPLES 1 TO 2

### (Preparation of aluminum support)

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 Coulomb/dm². Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness of the aluminum plate was measured and found to be 0.3 µm (Ra value according to JIS B 0601).

### (Coating of undercoat layer)

On the aluminum support thus-obtained was coated a coating solution for undercoat layer having the composition shown below using a wire bar, followed by drying using a hot air drying apparatus at 90°C for 30 seconds. A coating amount of the undercoat layer after drying was 10 mg/m².

### <Coating solution for undercoat Layer>

| | |
|---|---|
| Copolymer of ethyl methacrylate and sodium 2-acrylamido-2-methyl-1-propanesulfonate (75:25 in a molar ratio)(molecular weight: 1.8 x 10⁴) | 0.1 g |
| 2-Aminoethylphosphonic acid | 0.1 g |
| Methanol | 50 g |
| Ion-exchanged water | 50 g |

### (Coating of photosensitive layer)

A coating solution for photosensitive layer having the composition shown below was prepared and coated on the undercoat layer so as to have a thickness after drying of 1.15 g/m² by a wheeler, followed by drying at 100°C for one minute.

### <Coating solution for photosensitive layer>

| | |
|---|---|
| Ethylenically unsaturated compound: pentaerythritol tetraacrylate | 1.5 g |
| Binder: having the structure shown below | 1.8 g |
| Sensitizing dye: having the structure shown below | 0.1 g |
| Photopolymerization initiator: having the structure shown below | 0.15 g |
| Co-sensitizer: having the structure shown below | 0.2 g |
| Colored pigment dispersion: having the composition shown below | 1.5 g |
| Thermal polymerization inhibitor: N-nitrosophenylhydroxylamine | 0.01 g |
| Surfactant: Megafac F176, produced by Dainippon Ink & Chemicals, Inc. | 0.02 g |
| Methyl ethyl ketone | 20.0 g |
| Propylene glycol monomethyl ether | 20.0 g |

### Binder:

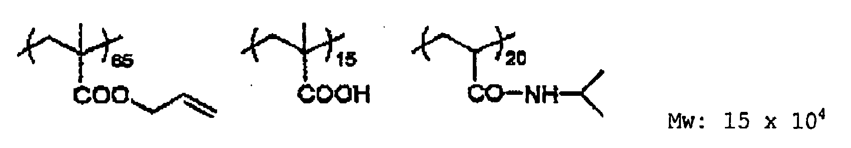

### Sensitizing dye:

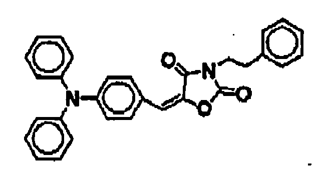

### Polymerization initiator:

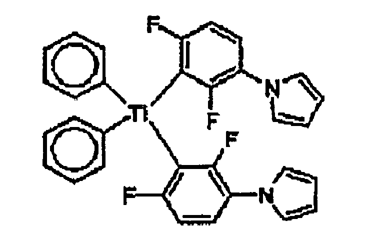

### Co-sensitizer:

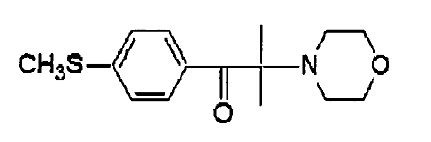

### <Composition of colored pigment dispersion>

| | |
|---|---|
| Pigment Blue 15:6 | 15 parts by weight |
| Copolymer of allyl methacrylate and methacrylic acid (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

### (Coating of overcoat layer)

A coating solution for overcoat layer having he composition shown below was coated on the photosensitive layer so as to have a dry coating amount of 2 g/m² and dried at 100°C for 2 minutes.

### <Coating solution for overcoat Layer>

| | |
|---|---|
| Polyvinyl alcohol (saponification degree: 98% by mole, polymerization degree: 550) | 4 g |
| Polyvinyl pyrrolidone (molecular weight: 10 x 10⁴) | 1 g |
| Ion-exchanged water | 95 g |

The photosensitive lithographic printing plate thus-obtained was further subjected to heat treatment under the conditions shown in Table 1 below to obtain photosensitive lithographic printing plates as the final object, respectively.

**Table 1: Conditions of Heat Treatment**

| | Temperature of Heat Treatment (°C) | Time for Heat Treatment (days) |
|---|---|---|
| Examples 1, 4 and 7 | 30 | 5 |
| Examples 2, 5 and 8 | 35 | 5 |
| Examples 3, 6 and 8 | 50 | 5 |
| Comparative Examples 1, 3 and 5 | 70 | 5 |
| Comparative Examples 2, 4 and 6 | 20 (room temperature) | 5 |

### (Evaluation of photosensitive lithographic printing plate)

### (1) Sensitivity

In the day when the heat treatment had been finished, the photosensitive lithographic printing plate was imagewise exposed using Setter Vx9600CTP, produced by Fuji Photo Film Co., Ltd. in a setter exposure amount of 0.50 µJ/cm² and then subjected to development/plate-making using an automatic developing machine (LP-850P2, produced by Fuji Photo Film Co., Ltd.) set a preheat temperature at 100°C and fed with a developer shown below and a finisher FP-2W, produced by Fuji Photo Film Co., Ltd., respectively, under conditions of developer temperature of 28°C and development time of 20 seconds to obtain a lithographic printing plate. The overcoat layer was removed by washing with water (25°C) for 10 seconds in the automatic developing machine. The cyan density of the image area of the lithographic printing plate obtained by development was measured by a Macbeth reflection densitometer RD-918 through a red filter loaded in the densitometer. A reciprocal of the exposure amount necessary to obtain density of 1.5 measured was taken as the index of sensitivity.

With respect to the result of evaluation, a sensitivity reaching rate is indicated, when the sensitivity of the photosensitive lithographic printing plate stored at 25°C for 6 months after the preparation is taken as 100. The larger the value, the more stable the sensitivity is.

### <Developer: aqueous solution having pH of 11. 6 and the composition shown below>

| | |
|---|---|
| Sodium hydroxide | 0.15 parts by weight |
| Compound shown below | 5.0 parts by weight |
| Ethylenediaminetetraacetate·4Na salt | 0.1 part by weight |
| Water | 94.75 parts by weight |

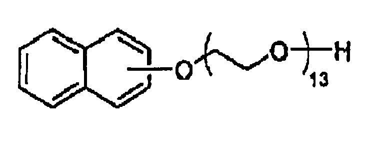

### (2) Printing durability

The lithographic printing plate obtained was subjected to printing using a printing machine (Lithrone, produced by Komori Corp.) and a number of printing sheets without defect, for example, ink thin spot was evaluated. The larger the number, the higher the printing durability is. The results are shown in Table 2 below.

**Table 2: Evaluation Results**

| | Sensitivity (%) | Printing Durability (x 10⁴ sheets) |
|---|---|---|
| Example 1 | 90 | 7.8 |
| Example 2 | 100 | 8.0 |
| Example 3 | 105 | 8.0 |
| Comparative Example 1 | 80 | 7.5 |
| Comparative Example 2 | 70 | 6.5 |

As shown in Table 2, the photosensitive lithographic printing plates of Examples 1 to 3 exhibit the stable sensitivity due to the heat treatment and also high printing durability. On the contrary, the photosensitive lithographic printing plates of Comparative Examples 1 to 2 are insufficient in both the sensitivity and the printing durability.

### EXAMPLES 4 TO 6 AND COMPARATIVE EXAMPLES 3 TO 4

Photosensitive lithographic printing plates for Examples 4 to 6 and Comparative Examples 3 to 4 were prepared in the same manner as in the preparation of the photosensitive lithographic printing plates in Examples 1 to 3 and Comparative Examples 1 to 2 except for changing the ethylenically unsaturated compound and binder to those shown below, respectively. After conducting the heat treatment under the conditions shown in Table 1, the evaluations were performed in the same manner as in Examples 1 to 3 and Comparative Examples 1 to 2. The results are shown in Table 3 below.

| | |
|---|---|
| Ethylenically unsaturated compound: having the structure shown below | 1.8 g |

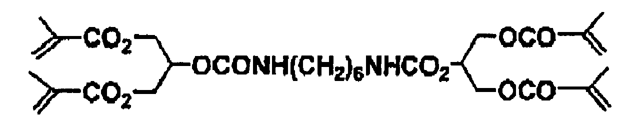

| | |
|---|---|
| Binder: having the structure shown below | 1.8 g |

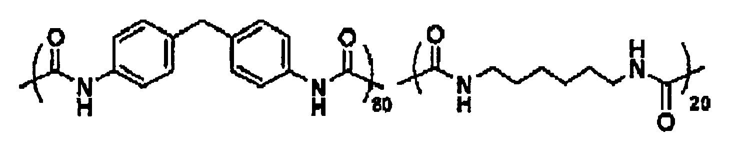

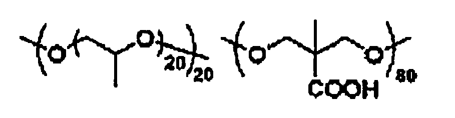

**Table 3: Evaluation Results**

| | Sensitivity (%) | Printing Durability (x 10⁴ sheets) |
|---|---|---|
| Example 4 | 90 | 9.5 |
| Example 5 | 100 | 10.0 |
| Example 6 | 105 | 9.5 |
| Comparative Example 3 | 85 | 8.0 |
| Comparative Example 4 | 65 | 7.0 |

As shown in Table 3, the photosensitive lithographic printing plates of Examples 4 to 6 exhibit the stable sensitivity due to the heat treatment and also high printing durability. On the contrary, the photosensitive lithographic printing plates of Comparative Examples 3 to 4 are insufficient in both the sensitivity and the printing durability.

### EXAMPLES 7 TO 9 AND COMPARATIVE EXAMPLES 5 TO 6

Photosensitive lithographic printing plates for Examples 7 to 9 and Comparative Examples 5 to 6 were prepared in the same manner as in the preparation of the photosensitive lithographic printing plates in Examples 1 to 3 and Comparative Examples 1 to 2 except for changing the ethylenically unsaturated compound, binder, sensitizing dye, photopolymerization initiator and co-sensitizer to those shown below, respectively. After conducting the heat treatment under the conditions shown in Table 1, the evaluations were performed in the same manner as in Examples 1 to 3 and Comparative Examples 1 to 2. The results are shown in Table 4 below.

| | |
|---|---|
| Ethylenically unsaturated compound: having the structure shown below | 1.8 g |

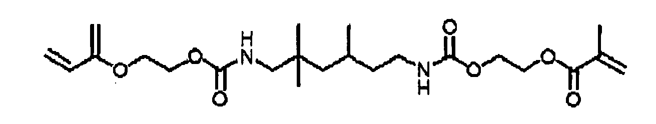

| | |
|---|---|
| Binder: having the structure shown below | 1.8 g |

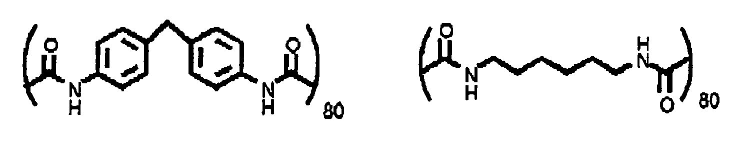

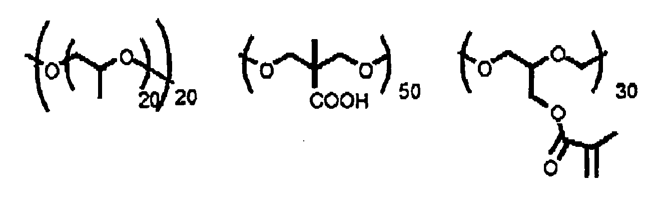

| | |
|---|---|
| Sensitizing dye: having the structure shown below | 0.1 g |

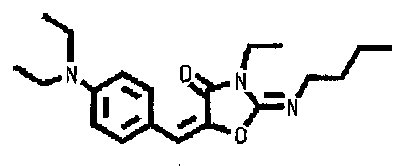

| | |
|---|---|
| Photopolymerization initiator: having the structure shown below | 0.4 g |

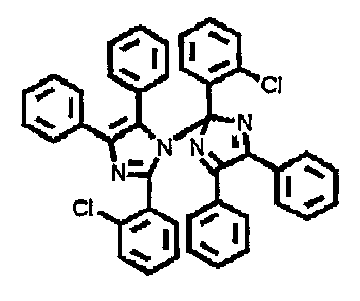

| | |
|---|---|
| Co-sensitizer: having the structure shown below | 0.2 g |

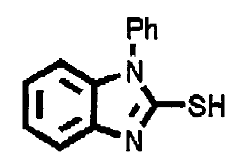

**Table 4: Evaluation Results**

| | Sensitivity (%) | Printing Durability (x 10⁴ sheets) |
|---|---|---|
| Example 7 | 95 | 10.0 |
| Example 8 | 100 | 10.5 |
| Example 9 | 100 | 10.8 |
| Comparative Example 5 | 85 | 7.8 |
| Comparative Example 6 | 85 | 7.5 |

As shown in Table 4, the photosensitive lithographic printing plates of Examples 7 to 9 exhibit the stable sensitivity due to the heat treatment and also high printing durability. On the contrary, the photosensitive lithographic printing plates of Comparative Examples 5 to 6 are insufficient in both the sensitivity and the printing durability.

This application is based on Japanese Patent application JP 2006-267851, filed September 29, 2006, the entire content of which is hereby incorporated by reference, the same as if fully set forth herein.

Although the invention has been described above in relation to preferred embodiments and modifications thereof, it will be understood by those skilled in the art that other variations and modifications can be effected in these preferred embodiments without departing from the scope and spirit of the invention.

## Claims

1. A method for preparation of a photosensitive lithographic printing plate comprising a support, a photopolymerizable photosensitive layer containing an addition-polymerizable compound having an ethylenically unsaturated double bond, an alkali-soluble or alkali-swellable binder and a photopolymerization initiator and an overcoat layer provided in this order, the method comprising: conducting heat treatment of the photosensitive lithographic printing plate having the photopolymerizable photosensitive layer which is dried at a temperature of from 30 to 60°C.

2. The method for preparation of a photosensitive lithographic printing plate as claimed in Claim 1, wherein the heat treatment is conducted after formation of the overcoat layer.

3. The method for preparation of a photosensitive lithographic printing plate as claimed in Claim 1 or 2, wherein the heat treatment is conducted at a temperature of from 35 to 50°C.

4. The method for preparation of a photosensitive lithographic printing plate as claimed in any one of Claims 1 to 3, wherein time for the heat treatment is at least 5 days.

5. The method for preparation of a photosensitive lithographic printing plate as claimed in any one of Claims 1 to 3, wherein time for the heat treatment is at least 10 days.

6. The method for preparation of a photosensitive lithographic printing plate as claimed in any one of Claims 1 to 5, wherein the addition-polymerizable compound having an ethylenically unsaturated double bond is a compound having four or more ethylenically unsaturated double bonds in a molecule.
